# EUROPEAN PATENT APPLICATION

(11) **EP 4 586 645 A1**
(43) Date of publication of application: **16.07.2025**
(21) Application number: 24158965.4
(22) Date of filing: 21.02.2024
(51) Int. Cl.: H04R 19/00, H04R 19/04

(54) **MEMS DEVICE**

(30) Priority: 11.01.2024 EP 24151305
(71) Applicant: Infineon Technologies AG, 85579 Neubiberg (DE)
(72) Inventor: FÜLDNER, Marc, 85579 Neubiberg (DE); ONARAN, Abidin Güclü, 81927 München (DE)
(74) Representative: Hersina, Günter

(57) **Abstract**

MEMS device (10) comprising a transducer element (12) having a first deflectable membrane structure (14), a rigid electrode structure (16) and a second deflectable membrane structure (18) in a vertically spaced configuration, wherein the rigid electrode structure (16) is arranged between the first (14) and second (18) deflectable membrane structures, wherein the first (14) and second (18) deflectable membrane structures each comprises a deflectable portion (14-1, 18-1), and wherein the deflectable portion (14-1) of the first deflectable membrane structure (14) and the deflectable portion (18-1) of the second deflectable membrane structure (18) are mechanically coupled by means of mechanical connection elements (20) to each other and are mechanically decoupled from the rigid electrode structure (16); a carrier element (22) for supporting the transducer element (12) and a plurality of clamping structures (24-1, ..., 24-#) for mechanically connecting the transducer element (12) to the carrier element (22) along spaced perimeter regions of the transducer element (12).

## Description

Embodiments of the present disclosure relate to a MEMS device (MEMS = micro electromechanical system). More specifically, embodiments relate to the field of MEMS sound transducers (MEMS microphones or MEMS loudspeakers), e.g. a sealed dual membrane (SDM) microphone or loudspeaker, with a bridge design, having a plurality of (spaced) clamping structures for (mechanically) anchoring the sound transducer element of the MEMS device along spaced perimeter regions to a carrier element

### Technical Background

The sensing of environmental parameters in the ambient atmosphere, such as sound with MEMS-based devices gains more and more importance in the implementation of appropriate sensors within mobile devices, home automation, such as Smart Home, and the automotive sector. MEMS devices, such as MEMS sound transducers (MEMS microphones or MEMS loudspeakers) function essentially as a transducer element capacitively converting an acoustic pressure wave into an analog electrical signal. The sound transducing mechanism in the MEMS microphone involves a variable capacitor having a fixed plate (back-plate or counter electrode) and at least one deflectable plate (membrane).

When designing capacitive MEMS devices, e.g. sound transducers (microphones or loudspeakers), it may be typically desirable to achieve a high signal-to-noise ratio (SNR) of the transducer output signal. The continuous miniaturization of transducers may pose new challenges with respect to the desired high signal-to-noise ratio.

As semiconductor technologies make further progress, a sealed dual-membrane (SDM) microphone has emerged to further improve key performance characteristics such as low noise and reliability. The SDM microphone typically comprises a top membrane, a bottom membrane, a perforated stator, a top oxide structure between the peripheral portions of the top membrane and the stator, a bottom oxide structure between the peripheral portions of the bottom membrane and the stator, and at least one pillar coupled between the top membrane and the bottom membrane. In conventional a SDM MEMS microphone, the transducer element is mechanically anchored by means of a further oxide structure along the entirety of its perimeter. Such a conventional SDM MEMS microphone has already a relatively high sensitivity and SNR (signal-to-noise ratio).

Therefore, there is an ongoing need in the field of MEMS devices, e.g., of MEMS transducers, to implement a MEMS device having further improved mechanical, operational and electrical characteristics, e.g., for providing a further improved performance with an increased sensitivity and/or SNR of the MEMS device.

Such a need can be solved by the MEMS device according to independent claim 1. Further, specific implementations of the MEMS device are defined in the dependent claims.

### Summary

According to an embodiment, a MEMS device comprises a transducer (microphone or loudspeaker) element having a first deflectable membrane structure, a rigid electrode structure (e.g. a stator or back-plate) and a second deflectable membrane structure in a vertically spaced configuration The rigid electrode structure is arranged between the first and second deflectable membrane structure, wherein the first and second deflectable membrane structures each comprise a deflectable portion, and wherein the deflectable portion of the first deflectable membrane structure and the deflectable portion of the second deflectable membrane structure are mechanically coupled by means of mechanical connection elements (e.g. pillars or columns) to each other and are mechanically decoupled from the rigid electrode structure. The MEMS device further comprises a carrier element for supporting the transducer element, and a plurality of clamping structures for mechanically connecting the transducer element to the carrier element along spaced perimeter regions of the transducer element.

The present disclosure describes a MEMS device which, for example, may be a MEMS sound transducer, e.g. a SDM MEMS microphone or loudspeaker, with an significantly increased mechanical compliance which results in an significantly increased mechanical sensitivity (when compared to conventional SDM microphone of the same physical dimensions). To be more specific, the MEMS device, e.g. in form of a SDM microphone, with the bridge or (double- or multiple-sided) cantilever SDM design may comprise an approximately three-times higher compliance (flexibility) of the membrane arrangement having the mechanically coupled first and second deflectable membrane structures 14, 18, when compared to conventional SDM microphone with the same physical dimensions (footprint or chip size).

Thus, the present approach of the MEMS device with the bridge design allows to achieve a very high compliance of the membrane arrangement, in particular, of a sealed dual membrane (SDM) microphone with two coupled membrane structures without increasing the size of the membrane arrangement (and with avoiding additional manufacturing cost).

Thus, the MEMS device with the bridge design allows to further improve both the sensitivity and the SNR, e.g. to further increase the performance of a SDM MEMS microphone. In particular, a high mechanical compliance, also referred to as membrane compliance or mechanical sensitivity and defined as the displacement amplitude of the membrane per unit incident sound pressure, is an important attribute for high operational performance of SDM MEMS microphones.

### Brief Description of the Figures

In the following, embodiments of the present disclosure are described in more detail while making reference to the accompanying drawings, in which:
- Figs. 1a-c: show a schematic top (plane) view and two schematic cross-sectional views of a MEMS device in accordance with an embodiment of the present disclosure;
- Figs. 2a-d: show schematic top (plane) views of the MEMS device with further exemplary implementations of the bridge or cantilever design of a MEMS device, e.g. a SDM microphone, in accordance with further embodiments of the present disclosure, and
- Figs. 3a-k: show schematic views of different implementations of the "pillar wall" of the transducer element of the MEMS device in accordance with further embodiments of the present disclosure.

Before discussing the present embodiments in further detail using the drawings, it is pointed out that in the figures and the specification identical elements and elements having the same functionality and/or the same technical or physical effect are usually provided with the same reference numbers or are identified with the same name, so that the description of these elements and of the functionality thereof as illustrated in the different embodiments are mutually exchangeable or may be applied to one another in the different embodiments.

### Detailed Description of the Figures

In the following description, embodiments are discussed in detail, however, it should be appreciated that the embodiments provide many applicable concepts that can be embodied in a wide variety of the field of dual-membrane MEMS sensors. The specific embodiments discussed are merely illustrative of specific ways to implement and use the present concept, and do not limit the scope of the embodiments. In the following description of embodiments, the same or similar elements or elements that have the same functionality are provided with the same reference sign or are identified with the same name, and a repeated description of elements provided with the same reference number or being identified with the same name is typically omitted. In the following description, a plurality of details is set forth to provide a more thorough explanation of embodiments of the disclosure.

However, it will be apparent to one skilled in the art that other embodiments may be practiced without these specific details. In other instances, well-known structures and devices are shown in block diagram form rather than in detail in order to avoid obscuring examples described herein. In addition, features of the different embodiments described herein may be combined with each other, unless specifically noted otherwise.

It is understood that when an element is referred to as being "connected" or "coupled" to another element, it may be directly connected or coupled to the other element, or intermediate elements may be present. Conversely, when an element is referred to as being "directly" connected to another element, "connected" or "coupled," there are no intermediate elements. Other terms used to describe the relationship between elements should be construed in a similar fashion (e.g., "between" versus "directly between", "adjacent" versus "directly adjacent", and "on" versus "directly on", etc.).

For facilitating the description of the different embodiments, the figures comprise a Cartesian coordinate system x, y, z, wherein the x-y-plane corresponds, i.e. is parallel, to a first main surface region of a substrate (= a reference plane = x-y-plane), wherein the direction vertically up with respect to the reference plane (x-y-plane) corresponds to the "+z" direction, and wherein the direction vertically down with respect to the reference plane (x-y-plane) corresponds to the "-z" direction. In the following description, the term "lateral" means a direction parallel to the x- and/or y-direction, i.e. parallel to the x-y-plane, wherein the term "vertical" means a direction parallel to the z-direction.

In the following description, a thickness of an element usually indicates a vertical dimension of such an element. In the figures, the different elements are not necessarily drawn to scale. Thus, the illustrated dimensions of the different elements may not be necessarily drawn to scale.

In the description of the embodiments, terms and text passages placed in brackets (next to a described element or function) are to be understood as further explanations, exemplary configurations, exemplary additions and/or exemplary alternatives of the described element or function.

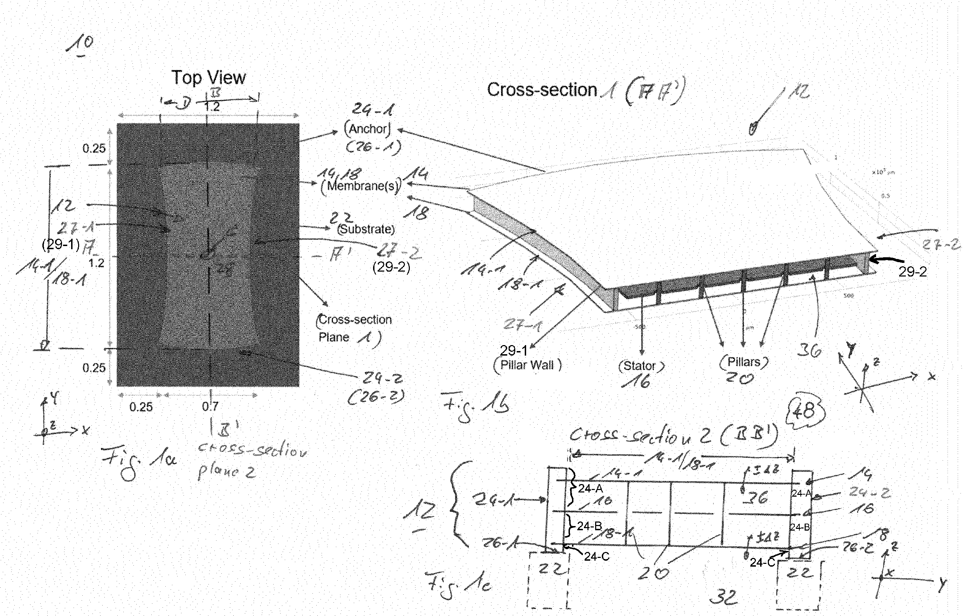

Fig. 1a exemplarily shows a schematic top view (parallel to the x-y-plane) of an exemplary MEMS device 10, Fig. 1b exemplarily shows a schematic cross-sectional view (parallel to the x-z plane) along a sectional line AA' (= cross-sectional plane 1) of the exemplary MEMS device 10, and Fig. 1c exemplarily shows a further schematic cross-sectional view (parallel to the y-z plane) along a further sectional line BB' (= cross-sectional plane 2) of the exemplary MEMS device 10.

As shown in Figs. 1a-c, the MEMS device 10 comprises a (sound) transducer element (e.g. a microphone element or a loudspeaker element) 12 having a first deflectable membrane structure 14, a rigid electrode structure (stator or back-plate) 16 and a second deflectable membrane structure 18 in a vertically spaced configuration, wherein the rigid electrode structure 16 is arranged between the first deflectable membrane structure 14 and the second deflectable membrane structure 18. The first deflectable membrane structure 14 and second deflectable membrane structure 18 each comprise a deflectable portion 14-1, 18-1, and wherein the deflectable portion 14-1 of the first deflectable membrane structure 14 and the deflectable portion 18-1 of the second deflectable membrane structure 18 are mechanically coupled by means of mechanical connection elements (e.g. in form of pillars or columns) 20 to each other and are mechanically decoupled from (= deflectable with respect to) the rigid electrode structure 18.

The MEMS device 10 further comprises a carrier element 22 for supporting the transducer element 12. The carrier element 22 may comprise a substrate or a semiconductor (e.g. Si) substrate. The MEMS device 10 further comprises a plurality of clamping (or anchor) structures 24-1, ..., 24-# for mechanically connecting (anchoring) the transducer element 12 to the carrier element 22 along spaced perimeter regions (spaced clamping regions) 26-1, ..., 26-# of the transducer element 12. The MEMS device 10 as exemplarily shown Figs. 1a-c comprises two (laterally opposing) clamping or anchor structures 24-1, 24-2 for mechanically connecting (anchoring) the transducer element 12 to the carrier element 22 along the spaced perimeter regions 26-1, 26-2 of the transducer element 12.

Along and laterally between the (unclamped) spaced perimeter regions 27-1, 27-2, the transducer element 12 is mechanically decoupled (unclamped) from the carrier element 22 and, thus, displaceable (deflectable) with respect to the carrier element 22.

To be more specific, the deflectable portion 14-1 of the first deflectable membrane structure 14 and the deflectable portion 18-1 of the second deflectable membrane structure 18 of the transducer element 12 extend between the opposing clamping (anchor) structures 24-1, 24-2 (at the spaced perimeter regions 26-1, 26-1) and are further mechanically decoupled from the carrier element 22 and, thus, displaceable (deflectable) with respect to the carrier element 22.

As exemplarily shown in Figs. 1a-c, the clamping (anchoring) structures 24-1, 24-2 along the spaced perimeter regions 26-1, 26-2 and the (unclamped) spaced perimeter regions 27-1, 27-2 may comprise a convex course or shape. However, the clamping (anchoring) structures 24-1, 24-2 along the spaced perimeter regions 26-1, 26-2 and the (unclamped) spaced perimeter regions 26-1, 26-2 may also pairwise (for symmetry reasons) comprise a convex, concave or straight course or shape. For symmetry reasons, the clamping structures 24-1, 24-2 may be equally spaced (equidistantly arranged) along the spaced perimeter regions (spaced clamping regions) 26-1, 26-2 and the (unclamped) spaced perimeter regions 27-1, 27-2 may also be equally spaced (equidistantly arranged) along the perimeter of the transducer element 12.

Thus, according to an embodiment, the (sound) transducer element 12 of the MEMS device 10 is mechanically anchored (coupled) along of at least two perimeter regions 26-1, 26-2 of the transducer element 12 (in contrast to a transducer element of a conventional SDM MEMS microphone where the transducer element is mechanically anchored (constraint) along its complete perimeter like a trampoline or drum membrane). Thus, embodiments of the MEMS device 10 may provide a bridge or (double-/multiple-sided) cantilever design of the MEMS device 10, e.g. bridge or cantilever design of a SDM microphone 10. This arrangement of the MEMS device 10 improves the compliance and, thus, the mechanical sensitivity of the membrane arrangement having the mechanically coupled first and second deflectable membrane structures 14, 18 and, hence, the overall operational performance of the MEMS device.

According to the embodiment, The MEMS device 10, e.g. in form of a SDM microphone, with the bridge or (double-sided) cantilever SDM design may achieve (at least) an approximately three-times higher compliance (flexibility) of the membrane arrangement having the mechanically coupled first and second deflectable membrane structures 14, 18 when compared to conventional SDM microphone of the same physical dimensions (footprint or chip size).

As exemplarily shown in Figs. 1a-b, the MEMS device 10 may have the following typical dimensions. The footprint (vertical projection) of the MEMS device 10 may have a first lateral dimension (= width along AA') between 0.5 and 2.0 mm and of about 1.2 mm and may have a second lateral dimension (= length along BB') between 0.5 and 2.0 mm and of about 1.7 mm. The deflectable membrane structures 14, 18 may have a first lateral dimension (= width along AA') between 0.3 and 1.8 mm and of about 0.7 mm. The rigid electrode 16 may have a first lateral dimension (= width along AA') between 0.3 and 1.8 mm and of about 0.7 mm. The deflectable membrane structures 14, 18 may have a second lateral dimension (length along BB') between 0.3 to 1.8 mm and of about 1.2 mm. The rigid electrode 16 may have a second lateral dimension (= length along BB') between 0.3 to 1.8 mm and of about 1.2 mm. The deflectable membrane structures 14, 18 may be vertically spaced by a distance between 1 µm and 10.0 µm and about 4.0 µm and may have a thickness of about 0,2 to 1 µm, the rigid electrodes may have thickness of about 0,2 to 2 µm, and the vertical gap (spacing in a rest (= not-deflected) condition) between the opposing layers (rigid electrodes - deflectable membranes) may be about 0.5 to 5µm.

The terms "electrode structure" and "membrane structure" are intended to illustrate that the membrane structures and the rigid electrode structure(s), respectively, can comprise a semi-conductive or conductive layer or, also, a layer sequence or layer stack having a plurality of different layers, wherein at least one of the layers is electrically conductive, e.g. a (highly-doped) conductive poly-silicon layer or a metallic layer.

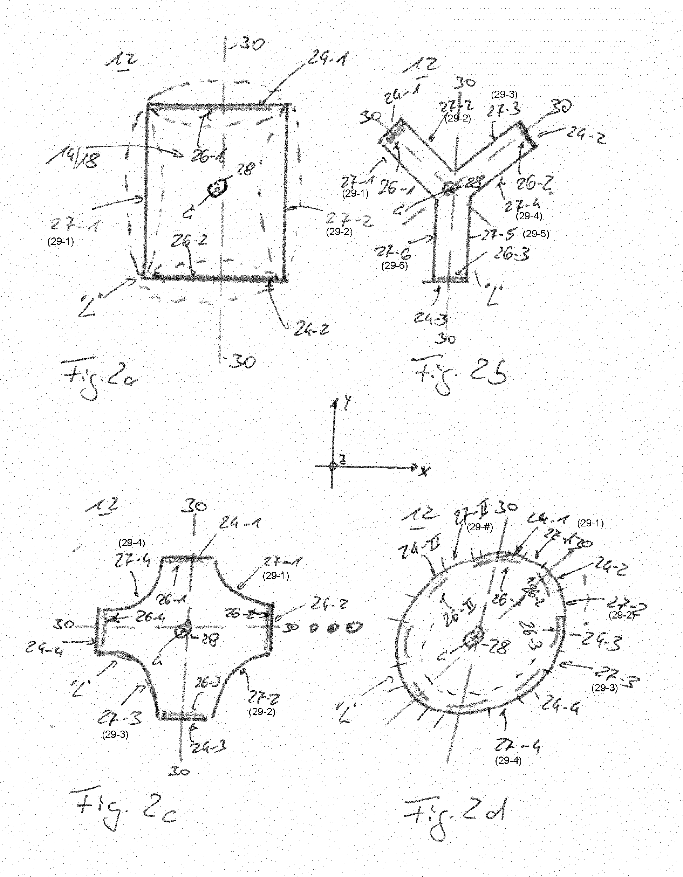

In the following, also referring to Figs. 2a-d, different embodiments of the MEMS device 10 with additional geometrical and structural implementations and configurations are described, wherein the described additional geometrical and structural implementations and configurations of the MEMS device 10 further contribute to the improvement of the compliance of the membrane arrangement of the (sound) transducer element 12 having the mechanically coupled first and second deflectable membrane structures 14, 18.

Figs. 2a-d show schematic top (plane) views of the MEMS device 10 with further exemplary implementations of the bridge or (multiple) cantilever design of the MEMS device 10, e.g. in form of a SDM sound transducer (microphone or loudspeaker), in accordance with further embodiments of the present disclosure.

As exemplarily shown in Fig. 2a, the (sound) transducer element 12 having the membrane arrangement having the mechanically coupled first and second deflectable membrane structures 14, 18 may comprise rectangular shape (in the lateral plane).

The clamping (anchoring) structures 24-1, 24-2 along the spaced perimeter regions (spaced clamping regions) 26-1, 26-2 and the (unclamped) spaced perimeter regions 27-1, 27-2 may comprise a straight course or shape resulting in a rectangular (lateral) shape of the footprint (base area) of the (sound) transducer element 12 (see the continuous line of Fig. 2a). However, the clamping (anchoring) structures 24-1, 24-2 along the spaced perimeter regions 26-1, 26-2 and the (unclamped) spaced perimeter regions 27-1, 27-2 may also pairwise (for symmetry reasons) comprise a convex, concave or straight course or shape (see also the dashed lines of Fig. 2a).

Thus, the MEMS device 10 of Fig. 2a comprises bridge or double-sided cantilever design, which can also be regarded as a "two-arm" configuration, wherein the two arms extending form a geometrical center region (or center point) 28 of the transducer element 12.

Thus, as exemplarily shown in Fig. 2a, the MEMS device 10 may comprise a transducer element 12, which may have a polygonal shape with an even number of sides, or edges. The shape of the transducer element 12 further may be a simple convex polygon. As exemplarily illustrated in Fig. 2a, the transducer element 12 may be clamped, or mechanically anchored, to the carrier element (or substrate) 22 along two opposite sides, or edges, 26-1, 26-2.

As exemplarily shown in Figs. 2b-d, the (sound) transducer element 12 having the membrane arrangement with the mechanically coupled first and second deflectable membrane structures 14, 18 may comprise a multiple-arm configuration.

Fig. 2b exemplarily shows a three-arm configuration, wherein the transducer element 12 may be clamped or mechanically anchored to the carrier element (or substrate) 22 along three sides with three clamping or anchoring structures 24-1, 24-2, 24-3 along the spaced perimeter regions 26-1, 26-2, 26-3.

The exemplarily configuration of Fig. 2b may also apply to any odd number, 2N+1 with N = 1, 2, 3, 4, ..., of arms, wherein the clamping (anchoring) structures 24-1, ..., 24-# (here: # = 2N+1) along the spaced perimeter regions 26-1,..., 26-# may also (e.g. all regions for symmetry reasons) comprise a convex, concave or straight course or shape, and wherein the (unclamped) spaced perimeter regions 27-1, ..., 27-# (# = 2N+1) may also (e.g. at least pairwise or all regions for symmetry reasons) comprise a convex, concave or straight course or shape.

Fig. 2c exemplarily shows a four-arm configuration, wherein the transducer element 12 may be clamped or mechanically anchored to the carrier element (or substrate) 22 along four sides with four clamping or anchoring structures 24-1, 24-2, 24-3, 24-4 along the spaced perimeter regions 26-1, 26-2, 26-3, 26-4.

The exemplarily configuration of Fig. 2c may also apply to any even number, 2N with N = 2, 3, 4, ..., of arms, wherein the clamping (anchoring) structures 24-1, ..., 24-# (here: # = 2N) along the spaced perimeter regions 26-1,..., 26-# and the (unclamped) spaced perimeter regions 27-1, ..., 27-# may also (e.g. at least pairwise or all regions for symmetry reasons) comprise a convex, concave or straight course or shape.

Fig. 2d exemplarily shows a round (e.g. circular, oval or elliptic) configuration of the (sound) transducer element 12, wherein the transducer element 12 may be clamped or mechanically anchored to the carrier element (or substrate) 22 along a plurality of (e.g. at least four) perimeter segments with the clamping or anchoring structures 24-1, ... , 24-# along the (e.g. at least four) spaced perimeter regions 26-1, ..., 26-#.

The transducer element 12 may comprise a number of shapes, wherein the list of shapes of the transducer element 12, exemplarily shown in Figs. 1a-c and 2a-d may not be regarded as exhaustive, wherein the below described additional geometrical and structural implementations and configurations of the MEMS device 10 may further contribute to the improvement of the compliance of the membrane arrangement of the (sound) transducer element 12 having the mechanically coupled first and second deflectable membrane structures 14, 18.

According to an embodiment, as exemplarily shown in Figs. 1a-c and 2a-d, the combined length of the clamping structures 24-1, ..., 24-# along the perimeter of the transducer element 12 may be equal or less than (≤) 50 % of the (overall) perimeter length L of the transducer element 12. Further, a lateral bisecting line 30 through each of the clamping regions (spaced perimeter regions) 26-1, ..., 26-# may pass through a geometrical center region (or point) 28 of the transducer element 12.

According to an embodiment, the geometrical center region 28 may have a lateral extension around the geometric center point "C" of the transducer element 12 which may be less than 1 %, 3% or 5 % of the overall lateral extension (or diameter) "D" of the transducer element 12.

According to an embodiment, as exemplarily shown in Figs. 1a-c and 2a-d, the clamping regions 26-1, ..., 26-# may be equally spaced (equidistantly arranged) along the perimeter of the transducer element 12. The (unclamped) equally spaced perimeter regions 27-1, ..., 27-# are arranged along the perimeter of the transducer element 12 between the equally spaced clamping regions 26-1, ..., 26-#.

According to an embodiment, as exemplarily shown in Figs. 1a-c and 2a, 2c, 2d, the plurality of clamping structures 24-1, ..., 24-# may comprise 2N clamping structures, with N = 1, 2, 3, 4, ..., wherein the respective lateral bisecting line 30 passes through two opposing clamping regions (spaced perimeter regions) 26-1, 26-2, ..., 26-# and the geometrical center region 28 of the transducer element 12.

According to an embodiment, as exemplarily shown in Figs. and 2b and 2d, the plurality of clamping structures 24-1, ..., 24-# may comprise 2N+1 clamping structures, with N = 1, 2, 3, 4, ..., wherein each lateral axis of symmetry of the transducer element 12 passes through a clamping structure 24-1, ..., 24-# and the geometrical center region 28 of the transducer element 12.

According to an embodiment, as exemplarily shown in Figs. 1a-c and 2a-d, the (sound) transducer element 12 of the MEMS device 10 may have a microphone and/or loudspeaker functionality. Thus, the MEMS device 10 may be implemented as a MEMS microphone or MEMS loudspeaker, e.g. a sealed dual membrane (SDM) microphone or loudspeaker with a bridge design.

Microphones are used for sensing or detecting ambient sound. Loudspeakers are used for emitting acoustic or ultrasonic sound to the environment. Thus, the sound transducer element 10 may be formed as a sensor (e.g., a microphone or pressure sensor) or as an actuator (e.g., a loudspeaker).

In case of an implementation of the sound transducer element 12 as a capacitive sensor, the deflection ±Δz of the membrane arrangement having the mechanically coupled first and second deflectable membrane structures 14, 18 is based on the applied external pressure load. The deflection or displacement ±Δz of the deflectable membrane arrangement can then be detected and capacitively read out, in order to provide a corresponding (analog or AD-converted digital) output signal of the sound transducer element 12. The deflection ±Δz of the deflectable membrane arrangement is (generally) caused by acoustically induced (sound) pressure changes in the environment.

According to a further embodiment, the sound transducer element 12 may also be implemented as an actuator, e.g., in form of a loudspeaker (due to its mode of operation) that uses the capacitive effect for generating sound. The initial mechanical motion of the deflectable membrane arrangement is created by applying a (modulated) voltage between the first and second deflectable membrane structures 14, 18, wherein this motion is typically converted into audible sound or ultrasonic sound.

In the following, also referring to Figs. 1a-c and 2a-d, different embodiments of the MEMS device 10 with respect to the implementation as a MEMS microphone or MEMS loudspeaker, e.g. a sealed dual membrane (SDM) microphone or loudspeaker with a bridge design are described. The described bridge design of the MEMS device 10 improves the compliance and, thus, the mechanical sensitivity of the membrane arrangement having the mechanically coupled first and second deflectable membrane structures 14, 18 and, hence, the overall operational performance of the MEMS device in form of a MEMS microphone or MEMS loudspeaker, e.g. a sealed dual membrane (SDM) microphone or loudspeaker.

According to an embodiment, the (sound) transducer element 12 may be arranged on (over) an opening (void or cavity) 32 in the carrier element 22 (e.g. a substrate or a frame structure), to which the (sound) transducer element 12 may be attached. The deflectable portion 18-1 of the second deflectable membrane structure 18 may face the opening 32 in the carrier element (substrate or frame structure) 22.

The opening 32 in the carrier element 22 may have in a vertical projection essentially the same or a slightly laterally offset (enlarged) shape or course at the (unclamped) spaced perimeter regions 27-1, ..., 27-# of the transducer element 12 to allow the deflection ±Δz of the membrane arrangement having the mechanically coupled first and second deflectable membrane structures 14, 18 (= to allow the deflection ±Δz of the deflectable portions 14-1, 18-1 of the first and second deflectable membrane structure 14, 18).

According to an embodiment, the rigid electrode structure 16 may be formed as a perforated stator or back-plate with respect to the first and second deflectable membrane structure 14, 18.

Due to the bridge design of the MEMS device 10, the rigid electrode structure 16 may be mechanically clamped at the clamping regions 26-1, ..., 26-# by means of the clamping structures 24-1, ..., 24-# to the carrier element 22 and may mechanically decoupled from (deflectable with respect to) the carrier element 22 along the (unclamped) spaced perimeter regions 27-1, 27-2. As the membrane arrangement 14, 18 of the transducer element 12, which has the mechanically coupled first and second deflectable membrane structures 14, 18, is, for example, arranged over the opening 32 in the carrier element 22, the deflectable portions 14-1, 18-1 of the membrane arrangement 14, 18 of the transducer element 12 are mechanically decoupled (unclamped) from the carrier element 22 and, thus, displaceable (deflectable) with respect to the carrier element 22.

Each clamping structure 24-1, ..., 24-# may comprise a first isolator element 24-A between the peripheral portions of the top membrane 14 and the stator 16, a second isolator element 24-B between the peripheral portions of the bottom membrane 18 and the stator 16, wherein the transducer element 12 is mechanically anchored by means of a third isolator element 24-C of the clamping structures 24-1, ..., 24-# to the carrier element 22. The different isolator elements (e.g. oxide elements or layers) 24-A, 24-B, 24-C of the clamping structures 24-1, ..., 24-# are provided to mechanically fix the border regions of the membranes 14, 18 and the stator 16 with respect to the carrier element 22.

Moreover, the transducer element 12 of the MEMS device 10 comprises wall elements (pillar walls) 29-1, ..., 29-# at the unclamped spaced perimeter regions 27-1, ..., 27-#, wherein along and laterally between the (unclamped) spaced perimeter regions 27-1, ..., 27-#, the transducer element 12 is mechanically decoupled (unclamped) from the carrier element 22 and, thus, displaceable (deflectable) with respect to the carrier element 22.

The wall elements (pillar walls) 29-1, ..., 29-# may comprise the same material as the mechanical connection elements (pillars or columns) 20. Further, the wall elements (pillar walls) 29-1, ..., 29-# may comprise the same (lateral) thickness and (vertical) height as the mechanical connection elements 20. Thus, the wall elements (pillar walls) 29-1, ..., 29-# may be regarded in a vertical projection as line elements, while the mechanical connection elements may be regarded in a vertical projection as point elements.

As exemplarily shown Figs. 1a-c and 2a-d, the clamping structures 24-1, ..., 24-# and the wall elements (pillar walls) 29-1, ..., 29-# form a circumferential wall structure 40 along the perimeter of the transducer element 12, wherein the circumferential wall structure 40 laterally confines the cavity 36 against the environment 48.

As exemplarily shown Figs. 1a-c and 2a-d, the MEMS device 10 comprises (as a part of the circumferential wall structure 40) the at least two clamping or anchor structures 24-1, ..., 24-# for mechanically connecting (anchoring) the transducer element 12 to the carrier element 22 along the spaced perimeter regions 26-1, ..., 26-# of the transducer element 12.

Moreover, the wall elements (pillar wall) 29-1, ..., 29-# of the MEMS device 10 form (as a further part of the circumferential wall structure 40) the (unclamped) spaced perimeter regions 27-1, 27-2, wherein along and laterally between the (unclamped) spaced perimeter regions 27-1, 27-2, the transducer element 12 is mechanically decoupled (unclamped) from the carrier element 20 and, thus, displaceable (deflectable) with respect to the carrier element 20.

According to an embodiment, the sealed cavity 36 may comprises a low pressure region. The low pressure region, which is located within the sealed cavity 36, may comprise a reduced atmospheric pressure when compared to the environmental atmosphere, wherein, for example, the reduced atmospheric pressure in the low pressure region may be vacuum or near to vacuum.

The low pressure region may have an atmospheric pressure that may be less than an ambient pressure or a standard atmospheric pressure. To be more specific, according to an embodiment, the pressure in the low pressure region may be substantially a vacuum or a near-vacuum. Alternatively, the pressure in the low pressure region may be less than about 50% (or 40%, 25%, 10% or 1%) of the ambient pressure or the standard atmospheric pressure. The standard atmospheric pressure may be typically 101.325 kPa or 1013.25 mbar. The pressure in the low pressure region may also be expressed as an absolute pressure, for example less than 50, 40, 30 or less than 10 kPa.

As exemplarily shown in Figs. 1a-c and 2a-d, the transducer element 12 of the MEMS device 10 may have straight or slightly curved (slightly concave or slightly convex) wall elements (pillar wall) 29-1, ..., 29-#.

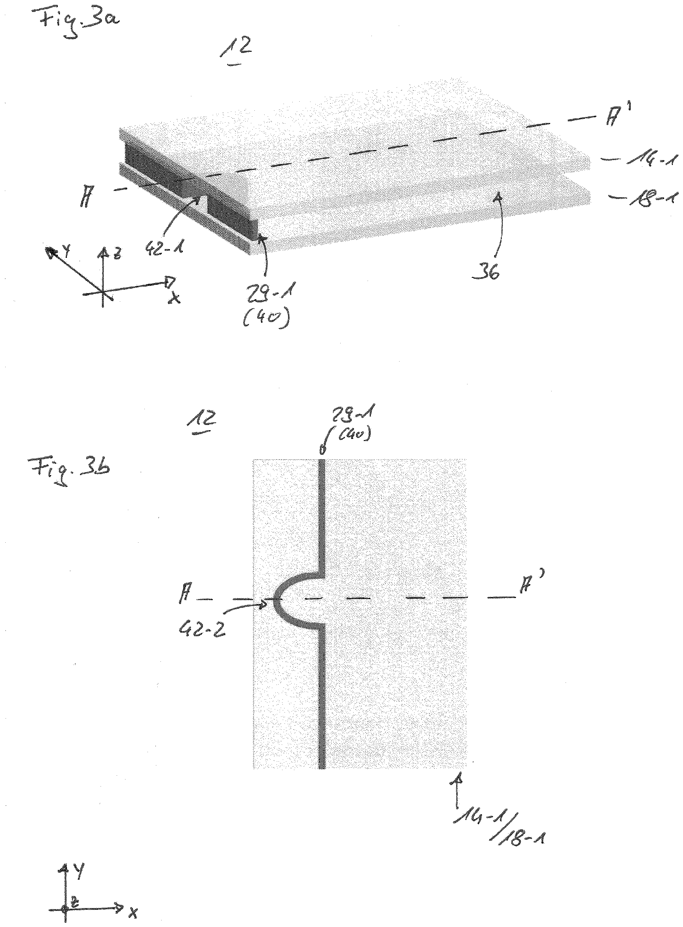

In the following, Figs. 3a-k exemplarily show schematic views of different implementations of the wall elements (pillar walls) 29-1, ..., 29-# of the transducer element 12 of the MEMS device 10 in accordance with further embodiments of the present disclosure.

According to an embodiment, at least one, a plurality or all of the wall elements 29-1, ..., 29-# may comprise a corrugated wall section (wall corrugation) 42-1, ..., 42-#, such as at least one or a plurality of corrugated wall sections 42-1, ..., 42-#. The wall elements 29-1, ..., 29-# of the transducer element 12 form the pillar wall which is arranged at a perimeter (border region) of the transducer element 12 between the deflectable portion 14-1 of the first deflectable membrane structure 14 and the deflectable portion 18-1 of the second deflectable membrane structure 18. The wall elements 29-1, ..., 29-# are mechanically decoupled from the rigid electrode structure 16.

The (respective) corrugated wall section(s) (wall corrugation) 42-1, ..., 42-# may have a curved (wavy), round, sinusoidal or semicircular shape, such as the shape of a section of a circle, oval or ellipse in a vertical projection (top view). In addition or alternatively, the (respective) corrugated wall section(s) (wall corrugation) 42-1, ..., 42-# may have a square, rectangular, triangle or sawtooth shape in a vertical projection (top view). The corrugated wall section(s) 42-1, 42-3, ... may extend into the cavity 36, e.g. may be curved inwards (concave) into the cavity 36. Alternatively or additionally, the corrugated wall section(s) 42-2, 42-4, ... may emerge (protrude) from the cavity 36, e.g. may be curved outwards (convex) from the cavity 36.

The corrugated wall section(s) 42-1, ..., 42-# may be arranged to reduce tensile stress in the wall elements 29-1, ..., 29-# of the transducer element 12, wherein, based on a reduced tensile stress, the membrane overall compliance (= the overall compliance of the transducer element 12) may be increased. The corrugated wall section(s) 42-1, ..., 42-# form an extension or elongation of the respective wall element 29-1, ..., 29-# with respect to the perimeter line of the transducer element 12.

The corrugated wall sections 42-1, ..., 42-# may be arranged on both opposing wall elements 29-1, ..., 29-# of an "arm" of the transducer element 12. Further, the corrugated wall sections 42-1, ..., 42-# may be arranged symmetrically arranged in a center region of an "arm" of the transducer element 12 or may be symmetrically arranged in a center region between both opposing clamping structures 24-1, .., 24-# of the transducer element 12, e.g. equally spaced from two opposing clamping structures 24-1, ..., 24-# of the transducer element 12. As a result, the corrugated pillar wall 29-1, ..., 29-# can (at least partly) relieve (reduce) a tensile stress by the wall elongation resulting in a higher overall compliance of the transducer element 12 of the MEMS device 10.

Referring to Figs. 3a-k, different embodiments of the MEMS device 10 with further geometrical and structural implementations and configurations are now described, wherein the described further geometrical and structural implementations and configurations of the MEMS device 10 contribute to the improvement of the compliance of the (sound) transducer element 12 (membrane arrangement) having the mechanically coupled first and second deflectable membrane structures 14, 18.

Fig. 3a exemplarily shows a schematic cross-sectional 3D-view of a portion (segment) of the transducer element 12 of the exemplary MEMS device 10, and Figs. 3b-k exemplarily show a further schematic top view (parallel to the x-y plane) of a portion (segment) of the transducer element 12 of the exemplary MEMS device 10. As exemplarily shown in Figs. 3a-j, the sectional line AA' (= cross-sectional plane 1) of the exemplary MEMS device 10 (see Figs. 1a-b, for example) may run through the center of the corrugated wall section(s) 42-1, ..., 42-# or may be parallel offset to the center of the corrugated wall section(s) 42-1, ..., 42-#.

As exemplarily shown in Fig. 3a, the wall element (pillar wall) 29-1 may comprise a single corrugated wall section 42-1, wherein the corrugated wall section 42-1 comprises in a vertical projection (top view) a curved, round, sinusoidal or semicircular shape, which extends in a direction into the cavity 36, i.e. is curved inwards into the cavity 36. Thus, the corrugated wall section 42-1 forms a lateral elongation (extension) of the wall element 29-1. The corrugated wall section 42-1 may have (in a vertical projection) the shape of a section of a circle, oval or ellipse, for example. Alternatively, the corrugated wall section 42-1 may have a square, rectangular, triangle or sawtooth shape.

As exemplarily shown in Fig. 3b, the wall element (pillar wall) 29-1 may comprise a single corrugated wall section 42-2, wherein the corrugated wall section 42-2 comprises (in a vertical projection) a curved, round, sinusoidal or semicircular shape, which extends in a direction emerging from the cavity 36, i.e. is curved outwards from the cavity 36. Thus, the corrugated wall section 42-2 forms a lateral elongation (extension) of the wall element 29-1 extending outwards from the cavity 36. The corrugated wall section 42-2 may have in a vertical projection (top view) the shape of a section of a circle, oval or ellipse, for example. Alternatively, the corrugated wall section 42-2 may have a square, rectangular, triangle or sawtooth shape.

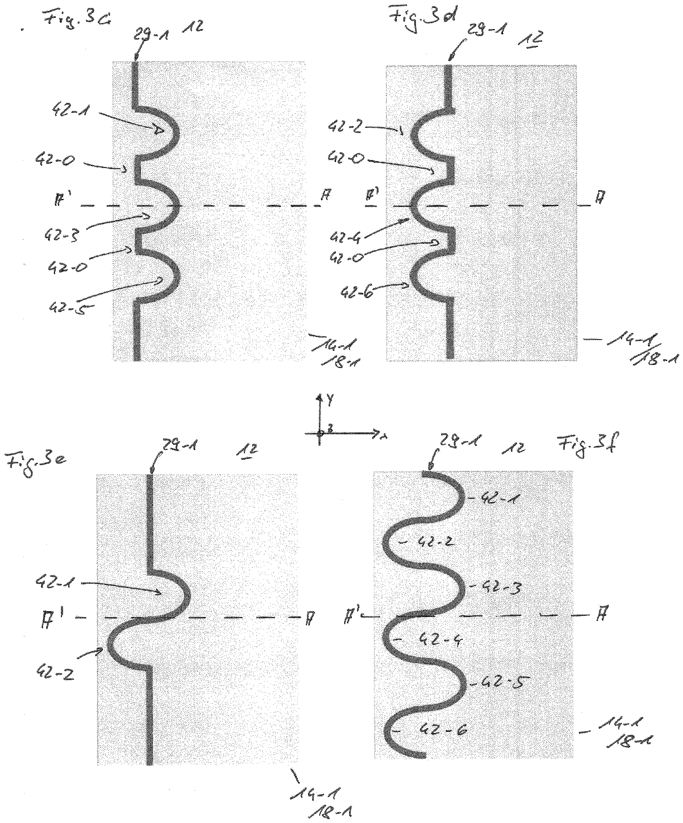

Fig. 3c exemplarily shows a configuration of the wall element (pillar wall) 29-1 comprising a plurality (e.g. three) of corrugated wall sections 42-1, 42-3, 42-5, wherein the corrugated wall section 42-1, 42-3, 42-5 are laterally spaced from each other by means of intermediate wall elements (spacers) 42-0 along the perimeter of the transducer element 12. The corrugated wall sections 42-1, 42-3, 42-5 may comprise (in a vertical projection) a curved, round, sinusoidal or semicircular shape, and extend in a direction into the cavity 36, i.e. are curved inwards into the cavity 36. Thus, the corrugated wall sections 42-1, 42-3, 42-5 form a lateral elongation (extension) of the wall elements 29-1. The corrugated wall sections 42-1, 42-3, 42-5 may have in a vertical projection the shape of a section of a circle, oval, or ellipse, for example. Alternatively, the corrugated wall sections 42-1, 42-3, 42-5 may have a square, rectangular, triangle or sawtooth shape.

As exemplarily shown in Fig. 3d, the wall element (pillar wall) 29-1 may comprise a plurality (e.g. three) corrugated wall sections 42-2, 42-4, 42-6. The corrugated wall sections 42-2, 42-4, 42-6 may comprise (in a vertical projection) a curved, round, sinusoidal or semicircular shape, and may extend in a direction emerging from the cavity 36, i.e., are curved outwards from the cavity 36. Further, intermediate wall elements (spacers) 42-0 are arranged between the plurality of corrugated wall sections 42-2, 42-4, 42-6 along the perimeter of the transducer element 12. Thus, the corrugated wall sections 42-2, 42-4, 42-6 form a lateral elongation of the wall element 29-1 extending outwards from the cavity 36. The corrugated wall sections 42-2, 42-4, 42-6 may have in a vertical projection, the shape of a section of a circle, oval or ellipse, for example. Alternatively, the corrugated wall sections 42-2, 42-4, 42-6 may have a square, rectangular, triangle or sawtooth shape.

As exemplarily shown in Fig. 3e, the wall element (pillar wall) 29-1 may comprise two corrugated wall sections 42-1, 42-2, wherein the corrugated wall sections 42-1, 42-2 comprise a curved, round, sinusoidal or semicircular shape (in a vertical projection). As shown in Fig. 3e, the corrugated wall section 42-1 extends in a direction into the cavity 36 (is curved inwards into the cavity 36), wherein the corrugated wall section 42-2 extends in a direction out of the cavity 36 (is curved outwards from the cavity 36). Thus, the corrugated wall sections 42-1, 42-2 form an elongation of the wall element (pillar wall) 29-1 in a "S"-configuration. According to an embodiment, the corrugated wall sections 42-1, 42-2 may be optionally spaced from each other by means of an intermediate wall element (spacer) 42-0 (as described with respect to Figs. 3c-d). The corrugated wall sections 42-1, 42-2 may have in a vertical projection, the shape of a section of a circle, oval or ellipse, for example. Alternatively, the corrugated wall sections 42-1, 42-2 may have a square, rectangular, triangle or sawtooth shape.

As exemplarily shown in Fig. 3f, the wall element (pillar wall) 29-1 may comprise a plurality of corrugated wall sections 42-1, ..., 42-6, wherein the corrugated wall sections 42-1, ..., 42-6 comprise a curved, round, sinusoidal or semicircular shape. As shown in Fig. 3f, the corrugated wall sections 42-1, 42-3, 42-5 extend in a direction into the cavity 36 (are curved inwards into the cavity 36), wherein the corrugated wall section 42-2, 42-4, 42-6 extend in a direction out of the cavity 36 (are curved outwards from the cavity 36). Thus, the corrugated wall sections 42-1, ..., 42-6 form an elongation of the wall element (pillar wall) 29-1 in a multiple (e.g. triple) "S"-configuration. According to an embodiment, the corrugated wall sections 42-1, ..., 42-6 may be optionally spaced from each other by means of intermediate wall elements (spacers) 42-0 (as described with respect to Figs. 3c-d). The corrugated wall sections 42-1, ..., 42-6 may have in a vertical projection, the shape of a section of a circle, oval or ellipse, for example. Alternatively, the corrugated wall sections 42-1, ..., 42-6 may have a square, rectangular, triangle or sawtooth shape.

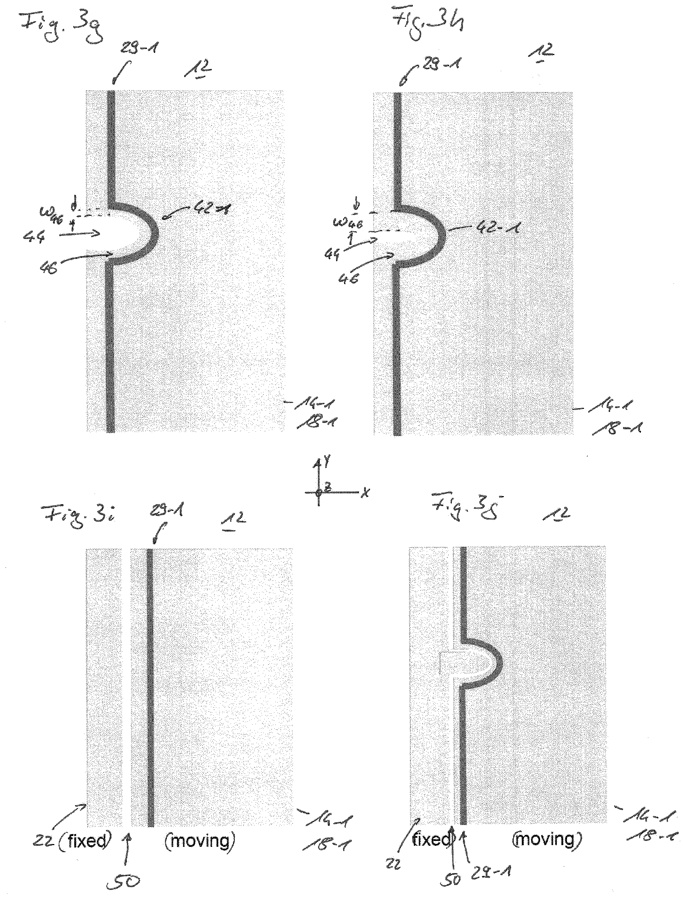

As exemplarily shown in Figs. 3g-h, the wall element (pillar wall) 29-1 may comprise a single corrugated wall section 42-1 (which is already described in Fig. 3a). As further shown in Fig. 3g-h, the deflectable portion 14-1 of the first deflectable membrane structure 14 and the deflectable portion 18-1 of the second deflectable membrane structure 18 of the transducer element 12 may comprise a recess (notch or slot) 44, wherein, in a vertical projection, the shape of the recess 44 extends (essentially) parallel to the shape of the corrugated wall section 42-1. The recess 44 of Fig. 3g is broader (larger) than the recess 44 of Fig. 3h. Thus, the width w₄₆ of the border region 46 at the corrugated wall section 42-1 of Fig. 3g is smaller than the width w₄₆ of the border region 46 at the corrugated wall section 42-1 of Fig. 3h.

In addition to the elongation of the wall element 29-1 by means of the corrugated wall section 42-1, the recess 44 in the deflectable portion 14-1 of the first deflectable membrane structure 14 and the deflectable portion 18-1 of the second deflectable membrane structure 18 of the transducer element 12 forms a corresponding elongation of the perimeter line of the transducer element 12. Thus, the overall compliance of the transducer element 12 of the MEMS device 10 can be further increased.

As exemplarily shown in Figs. 3i-j, the bridge design of the MEMS device 10 provides lateral ventilation through a ventilation slit 50 at the unclamped perimeter regions 27-1, 27-2 and, thus, allows an lateral air exchange for equalizing (as a low pass functionality) slow (static, e.g. temperature dependent) environmental pressure changes between both vertically opposing sides of the sound transducer element 12.

Fig. 3i shows an exemplary embodiment, wherein the ventilation slit 50, e.g. between a fixed element, such as the substrate 22, and the transducer element 12, has straight or slightly curved course which follows (is parallel to) the course of the wall element (pillar wall) 29-1. Fig. 3j shows an exemplary embodiment, wherein the ventilation slit 50 also follows (is parallel to) the course of the wall element (pillar wall) 29-1 having the corrugated wall section 42-1 and the recess 44. The fixed element 22 may have a lateral extension 22-1 which corresponds to the recess 44 of Figs. 3g-h.

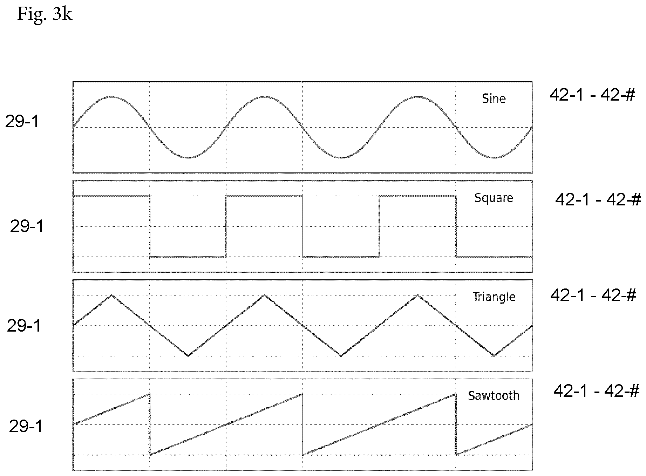

As exemplarily described with respect to Figs. 3a-j and 3k (sine), the wall element(s) 29-1, ..., 29-# may comprise a corrugated wall section (wall corrugation) 42-1, ..., 42-# with a curved, round, sinusoidal or semicircular shape, such as the shape of a section of a circle, oval or ellipse in a vertical projection (top view).

As exemplarily shown in Figs. 3k (square - triangle - sawtooth), the (respective) corrugated wall section(s) 42-1, ..., 42-# may alternatively have a square (rectangular), triangle or sawtooth shape in a vertical projection. The corrugated wall section(s) 42-1, 42-3, ... may extend into the cavity 36. Alternatively or additionally, the corrugated wall section(s) 42-2, 42-4, ... may emerge (protrude) from the cavity 36.

The above description with respect to Figs. 3a-j of the wall element(s) 29-1, ..., 29-# having at least one corrugated wall section 42-1, ..., 42-# with a curved, round, sinusoidal or semicircular shape is equally applicable to the wall element(s) 29-1, ..., 29-# having at least one corrugated wall section 42-1, ..., 42-# with a square, rectangular, triangle or sawtooth shape.

According to an embodiment, the mechanical connection elements 20 may comprise a pillar-shape or a column-shape between the two opposing deflectable membrane structures 14, 18.

According to an embodiment, the plurality of (pillar-shaped or column-shaped) mechanical connection elements 20 may be non-conductive, for example, in order to realize the first and second membrane structures 14, 18 as two electrically separated electrodes for a differential (read-out) operation, i.e. to allow a differential read out configuration of the first and second membrane structures 14, 18. Thus, the pillars can be made at least partially of an insulating material, wherein the pillars 20 can be made of an insulating material, like silicon, nitride, silicon oxide, a polymer or a combination of the former materials, or a combination of the former materials with a conductive layer (for instance silicon), provided the conductive part of the pillars is separated from the membrane structures 14, 18 by an insulating material.

According to a further embodiment, the plurality of (pillar-shaped or column-shaped) mechanical connection elements 20 may be conductive, for example, in order to realize an electrical connection of the first and second membrane structures 14, 18 as two electrically connected electrodes.

According to an embodiment, as exemplarily shown in Figs. 1a-c and 2a-d, the (sound) transducer element 12 of the MEMS device 10 be implemented as a MEMS microphone or MEMS loudspeaker, e.g. a sealed dual membrane (SDM) microphone with a bridge design.

To summarize, a (sealed) dual or multiple MEMS microphone 10 with a (vacuum) cavity 36 relies on a number of mechanically connection elements, also referred to as pillars or columns, 20, which are connecting both membrane structures 14, 18 (in case of a dual membrane arrangement), and prevent the membrane structures 14, 18 from collapsing because of the pressure loads on both membrane structures 14, 18, i.e., the external pressure onto the top of the top membrane structure 14 and the external pressure onto the bottom of the bottom membrane structure 18.

The mechanical connection elements 20 of a dual-membrane MEMS microphone 10 are equally applicable to a multiple-membrane MEMS microphone 10 having three or more membrane structures, wherein neighboring membrane structures are mechanically coupled by means of mechanical connection elements 20. In case, the MEMS device 10 is formed as a multiple-membrane MEMS microphone having three membrane structures, the MEMS device 10 may comprise a first and second rigid electrode structure and a first to third deflectable membrane structure in a vertically spaced configuration, e.g. in vertically separated and spaced configuration. The first rigid electrode structure is sandwiched between the first and second deflectable membrane structure, wherein the second rigid electrode structure is sandwiched between the second and third deflectable membrane structure. The first, second and third deflectable membrane structures each comprises a deflectable portion, wherein the deflectable portions of the first, second and third deflectable membrane structures are mechanically coupled to each other by means of the mechanical connection elements 20, and are mechanically decoupled from the first and second rigid electrode structures. This setting of the MEMS device 10 can be also applied to a multiple-membrane MEMS microphone having four or more membrane structures.

As exemplarily shown in Figs. 1a-c and 2a-d, the transducer element is depicted in its rest position, e.g. when no sound wave arrives at the deflectable membrane structures. An incident sound wave may cause the deflectable portion of the membrane structures 14-1, 18-1 to deflect. Further, the two deflectable membrane structures 14-1, 18-1 may be exposed to an ambient pressure and potentially a sound pressure. The top side of the first deflectable membrane structure 14-1 may also be regarded as a sound receiving main surface of the MEMS device 10. Additionally, the bottom side of the second deflectable membrane structure 18 may also be regarded as a sound receiving main surface of the MEMS device 10. When sound waves are incident on the membrane structures 14, 18, the membrane structures 14, 18 may deflect or oscillate. A displacement of one membrane (either of the two membrane structures 14-1. 18-1) may result in the corresponding displacement of the second membrane and vice versa. It is to be noted that in accordance with a plurality of embodiments, the membrane structures 14-1, 18-1 may be deflected in response to a change in pressure caused by an incident sound wave. Electrical signals may be generated by the deflection of the membrane structures 14-1, 18-1 and might be read out by a plurality of read-out circuits. The read-out circuits may process the electrical signals and may finally convert the electrical signals into useable information, as a possible last step of signal processing.

Figs. 2a-d show different exemplary schematic top (plane) view of the MEMS device 10 along with some possible implementations for the improvement of mechanical compliance or mechanical sensitivity. The shape of the transducer element 12 may be chosen or optimized for various targets and combinations thereof, e.g., chip size, capacitance, motor sensitivity, resonance frequency, etc. In particular, the shape and design of the transducer element 12 may even be optimized such that the mechanical compliance requirement may be achieved. The transducer element 12 may comprise a number of shapes, wherein the list of shapes of the transducer element 12 may not be regarded as exhaustive.

Further, Figs. 2a-d illustrate that the plurality of clamping, or mechanically anchored, structures 24-1, 24-2... 24-# spaced along perimeter regions (clamping regions) 26-1, 26-2, ..., 26-# of the transducer element 12 may be supported by means of the carrier element (or substrate) 22. The number of regions along which the transducer element 12 may be clamped to the substrate 22 may be, at least two or more. According to a further embodiment, the lines bisecting the spaced perimeter regions (clamping regions) 26-1, 26-2 ... 26-# may coincide with the (lateral) axis of symmetry of the transducer element 12.

Additional embodiments and aspects are described which may be used alone or in combination with the features and functionalities described herein.

According to an embodiment, a MEMS device comprises a transducer element having a first deflectable membrane structure, a rigid electrode structure (stator) and a second deflectable membrane structure in a vertically spaced configuration, wherein the rigid electrode structure is arranged between the first and second deflectable membrane structure, wherein the first and second deflectable membrane structures each comprise a deflectable portion, and wherein the deflectable portion of the first deflectable membrane structure and the deflectable portion of the second deflectable membrane structure are mechanically coupled by means of mechanical connection elements to each other and are mechanically decoupled from the rigid electrode structure; and a carrier element for supporting the transducer element; and a plurality of clamping structures for mechanically connecting the transducer element to the carrier element along spaced perimeter regions of the transducer element.

According to an embodiment, a the combined length of the clamping structures along the perimeter of the transducer element is equal or less than (≤) 50 % of the perimeter length of the transducer element, and wherein a lateral bisecting line through each of the clamping regions passes through a geometrical center region of the transducer element.

According to an embodiment, the clamping regions are equally spaced along the perimeter of the transducer element.

According to an embodiment, the plurality of clamping structures comprises 2N clamping structures, with N = 1, 2, 3, 4, ..., wherein the respective lateral bisecting line passes through two opposing clamping regions and the geometrical center region of the transducer element.

According to an embodiment, the plurality of clamping structures comprises 2N+1 clamping structures, with N = 1, 2, 3, 4, ..., wherein each lateral axis of symmetry of the transducer element passes through a clamping structure and the geometrical center region of the transducer element.

According to an embodiment, the geometrical center region has a lateral extension around the geometric center of the transducer element which is less than 5 % of the diameter of the transducer element.

According to an embodiment, the first and second deflectable membrane structures form a cavity against the environment, which is sealed against the environment.

According to an embodiment, the clamping structures at the spaced perimeter regions of the transducer element and wall elements at unclamped, spaced perimeter regions of the transducer element form a circumferential wall structure along the perimeter of the transducer element, wherein the circumferential wall structure laterally confines the cavity against the environment.

According to an embodiment, the cavity comprises a low pressure region, wherein the lower pressure region comprises a reduced atmospheric pressure when compared to the environmental atmosphere, wherein, for example, the reduced atmospheric pressure in the low pressure region is vacuum or near to vacuum.

According to an embodiment, at least one or all of the wall elements comprise a (at least one or a plurality of) corrugated wall section.

According to an embodiment, the corrugated wall section has a curved, round, sinusoidal or semicircular shape, e.g., the shape of a section of a circle, oval or ellipse, or wherein the corrugated wall section has a square, rectangular, triangle or sawtooth shape.

According to an embodiment, the corrugated wall section extends into the cavity and/or emerges from the cavity.

According to an embodiment, the mechanical connection elements comprise a plurality of pillar-shaped or a column-shaped mechanical connection elements between the two opposing deflectable membrane structures.

According to an embodiment, the plurality of pillar-shaped or column-shaped mechanical connection elements are non-conductive.

According to an embodiment, the rigid electrode structure forms a counter-electrode (stator) with respect to the first and second deflectable membrane structure,

According to an embodiment, the transducer element has a microphone and/or loudspeaker functionality.

Although some aspects have been described as features in the context of an apparatus, it is clear that such a description may also be regarded as a description of corresponding features of a method. Although some aspects have been described as features in the context of a method, it is clear that such a description may also be regarded as a description of corresponding features concerning the functionality of an apparatus.

Depending on certain implementation requirements, embodiments of the control circuitry can be implemented in hardware or in software or at least partially in hardware or at least partially in software. Generally, embodiments of the control circuitry can be implemented as a computer program product with a program code, the program code being operative for performing one of the methods when the computer program product runs on a computer. The program code may, for example, be stored on a machine-readable carrier.

In the foregoing detailed description, it can be seen that various features are grouped together in examples for the purpose of streamlining the disclosure. This method of disclosure is not to be interpreted as reflecting an intention that the claimed examples require more features than are expressly recited in each claim. Rather, as the following claims reflect, subject matter may lie in less than all features of a single disclosed example. Thus, the following claims are hereby incorporated into the detailed description, where each claim may stand on its own as a separate example. While each claim may stand on its own as a separate example, it is to be noted that, although a dependent claim may refer in the claims to a specific combination with one or more other claims, other examples may also include a combination of the dependent claim with the subject matter of each other dependent claim or a combination of each feature with other dependent or independent claims. Such combinations are proposed herein unless it is stated that a specific combination is not intended. Furthermore, it is intended to include also features of a claim to any other independent claim even if this claim is not directly made dependent to the independent claim.

Although specific embodiments have been illustrated and described herein, it will be appreciated by those of ordinary skill in the art that a variety of alternate and/or equivalent implementations may be substituted for the specific embodiments shown and described without departing from the scope of the present embodiments. This application is intended to cover any adaptations or variations of the specific embodiments discussed herein.

Therefore, it is intended that the embodiments be limited only by the claims and the equivalents thereof.

## Claims

1. MEMS device (10) comprising:
a transducer element (12) having a first deflectable membrane structure (14), a rigid electrode structure (16) and a second deflectable membrane structure (18) in a vertically spaced configuration,
wherein the rigid electrode structure (16) is arranged between the first and second deflectable membrane structure (14, 18), wherein the first and second deflectable membrane structures (14, 18) each comprise a deflectable portion (14-1, 18-1), and wherein the deflectable portion (14-1) of the first deflectable membrane structure (14) and the deflectable portion (18-1) of the second deflectable membrane structure (18) are mechanically coupled by means of mechanical connection elements (20) to each other and are mechanically decoupled from the rigid electrode structure (16); and
a carrier element (22) for supporting the transducer element (12); and
a plurality of clamping structures (24-1, ..., 24-#) for mechanically connecting the transducer element (12) to the carrier element (22) along spaced perimeter regions (26-1, ..., 26-#) of the transducer element (12).

2. The MEMS device (10) of claim 1, wherein the combined length of the clamping structures (24-1, ..., 24-#) along the perimeter of the transducer element (12) is equal or less than (≤) 50 % of the perimeter length (L) of the transducer element (12), and wherein a lateral bisecting line (30) through each of the clamping regions (26-1, ..., 26-#) passes through a geometrical center region (28) of the transducer element (12).

3. The MEMS device (10) of claims 1 or 2, wherein the clamping structures (24-1, ..., 24-#) are equally spaced along the perimeter of the transducer element (12).

4. The MEMS device (10) of the preceding claims, wherein the plurality of clamping structures (24-1, ..., 24-#) comprises 2N clamping structures, with N = 1, 2, 3, 4, ..., wherein the respective lateral bisecting line (30) passes through two opposing clamping regions (26-1, ..., 26-#) and the geometrical center region (28) of the transducer element (12).

5. The MEMS device (10) of claims 1 or 2 or 3, wherein the plurality of clamping structures (24-1, ..., 24-#) comprises 2N+1 clamping structures, with N = 1, 2, 3, 4, ..., wherein each lateral axis of symmetry (30) of the transducer element (12) passes through a clamping structure and the geometrical center region (28) of the transducer element (12).

6. The MEMS device (10) of any of the preceding claims, wherein the geometrical center region (28) has a lateral extension around the geometric center (C) of the transducer element (12) which is less than 5 % of the diameter of the transducer element (12).

7. The MEMS device (10) of any of the preceding claims, wherein the first and second deflectable membrane structures (14, 18) form a cavity (36) against the environment, which is sealed against the environment.

8. The MEMS device (10) of claim 7, wherein the clamping structures (24-1, ..., 24-#) at the spaced perimeter regions (26-1, ..., 26-#) of the transducer element (12) and wall elements (29-1, ..., 29-#) at unclamped, spaced perimeter regions (27-1, ..., 27-#) of the transducer element (12) form a circumferential wall structure (40) along the perimeter of the transducer element (12), wherein the circumferential wall structure (40) laterally confines the cavity (36) against the environment.

9. The MEMS device (10) of claim 7 or 8, wherein the cavity (36) comprises a low pressure region, wherein the lower pressure region comprises a reduced atmospheric pressure when compared to the environmental atmosphere, wherein, for example, the reduced atmospheric pressure in the low pressure region is vacuum or near to vacuum.

10. The MEMS device (10) of claim 8 or 9, wherein at least one or all of the wall elements (29-1, ..., 29-#) comprise a corrugated wall section (42-1, ..., 42-#).

11. The MEMS device (10) of claim 10, wherein the corrugated wall section (42-1, ..., 42-#) has a curved, round, sinusoidal or semicircular shape, e.g. the shape of a section of a circle, oval or ellipse, or wherein the corrugated wall section has a square, rectangular, triangle or sawtooth shape.

12. The MEMS device (10) of claim 10 or 11, wherein the corrugated wall section (42-1, ..., 42-#) extends into the cavity and/or emerges from the cavity.

13. The MEMS device (10) of any of the preceding claims, wherein the mechanical connection elements (20) comprise a plurality of pillar-shaped or a column-shaped mechanical connection elements between the two opposing deflectable membrane structures (14, 18).

14. The MEMS device (10) of claim 13, wherein the plurality of pillar-shaped or column-shaped mechanical connection (20) elements are non-conductive.

15. The MEMS device (10) of any of the preceding claims, wherein the rigid electrode structure (16) forms a counter-electrode with respect to the first and second deflectable membrane structure (14, 18).

16. The MEMS device (10) of any of the preceding claims, wherein the transducer element has a microphone and/or loudspeaker functionality.
